(19) Europäisches Patentamt
European Patent Office
Office européen des brevets

(11) **EP 3 153 472 A1**

(12) **EUROPÄISCHE PATENTANMELDUNG**

(43) Veröffentlichungstag:
**12.04.2017   Patentblatt 2017/15**

(21) Anmeldenummer: **16192872.6**

(22) Anmeldetag: **07.10.2016**

(51) Int Cl.:
$C01G\ 19/00$ (2006.01)        $B01J\ 23/00$ (2006.01)
$C01G\ 37/00$ (2006.01)        $C01G\ 45/12$ (2006.01)
$C01G\ 49/00$ (2006.01)        $C01G\ 51/00$ (2006.01)
$C01G\ 53/00$ (2006.01)        $C01G\ 55/00$ (2006.01)
$C01G\ 3/00$ (2006.01)         $C01G\ 5/00$ (2006.01)
$C01G\ 15/00$ (2006.01)        $C02F\ 9/00$ (2006.01)
$C11D\ 3/00$ (2006.01)         $G21F\ 9/00$ (2006.01)
$H01L\ 43/08$ (2006.01)        $H01L\ 31/00$ (2006.01)
$H01M\ 4/00$ (2006.01)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(30) Priorität: **09.10.2015   DE 102015117277**

(71) Anmelder:
• **Heuss-Aßbichler, Soraya**
  **81479 München (DE)**

• **John, Melanie**
  **80939 München (DE)**

(72) Erfinder:
• **Heuss-Aßbichler, Soraya**
  **81479 München (DE)**
• **John, Melanie**
  **80939 München (DE)**

(74) Vertreter: **Hofstetter, Schurack & Partner Patent- und Rechtsanwaltskanzlei PartG mbB Balanstrasse 57 81541 München (DE)**

(54) **VERFAHREN ZUM HERSTELLEN EINER ANORGANISCHEN VERBINDUNG DER ALLGEMEINEN FORMEL AXO2**

(57)    Die Erfindung betrifft ein Verfahren zum Herstellen einer anorganischen Verbindung der allgemeinen Formel $AXO_2$, in welcher A wenigstens ein Element aus der Gruppe Cu, Ag, Pd, Pt, Au, Na und Li und X wenigstens ein von A verschiedenes metallisches Element aus der Gruppe der Übergangsmetalle, der Leichtmetalle, der Seltenerdmetalle und/oder des p-Blocks sind. Das Verfahren umfasst die Schritte a) Bereitstellen einer wässrigen Lösung, die gelöste Kationen von A und X enthält, b) Einstellen einer Temperatur der wässrigen Lösung auf einen Wert von höchstens 95 °C, c) Einstellen eines pH-Werts der wässrigen Lösung auf einen Wert zwischen 0 und 14 unter Ausbildung von Fällungsprodukten und d) Alterung der Fällungsprodukte bei mindestens 35 °C für mindestens 10 Minuten unter Ausbildung von $AXO_2$. Die Erfindung betrifft weiterhin eine entsprechende anorganische Verbindung der allgemeinen Formel $AXO_2$ sowie deren Verwendungen.

**EP 3 153 472 A1**

**Beschreibung**

Die Erfindung betrifft ein Verfahren zum Herstellen einer anorganischen Verbindung der allgemeinen Formel $AXO_2$, in welcher A ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind. Die Erfindung betrifft weiterhin eine entsprechende anorganischen Verbindung der allgemeinen Formel $AXO_2$ sowie die Verwendung einer solchen anorganischen Verbindung.

Anorganische Verbindungen der allgemeinen Formel $AXO_2$, in welcher A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind, sind in verschiedenen Ausgestaltungen bekannt und können für vielfältige Zwecke eingesetzt werden. Ein Beispiel für eine solche Verbindung ist Delafossit ($Cu^{1+}Fe^{3+}O_2$), welcher üblicherweise bei hohen Temperaturen von mehr als 800 °C durch Festphasenreaktionen oder Sol-Gel Verfahren hergestellt wird. Alternativ sind hydrothermale Synthesen bekannt, die bei Temperaturen zwischen 500 °C und 700 °C und Verfahrensdrücken von 300 bar durchgeführt werden, bekannt. In manchen Fällen können die Temperaturen solcher hydrothermaler Synthesen auf etwa 180 °C oder weniger abgesenkt werden. Die hydrothermalen Synthesen werden in Autoklaven durchgeführt, das heißt in geschlossenen, druckstabilen Gefäßen, und verbleiben dort in der Regel mindestens 12 und meistens mehr als 24 Stunden. Es sind auch Reaktionen mit Zugabe von organischen Reduktionsmitteln wie beispielsweise Propionaldehyd (Propanal) bekannt.

Als nachteilig an den bekannten Herstellungsverfahren ist der Umstand anzusehen, dass diese aufgrund der komplizierten Reaktionsführung und der Notwendigkeit hoher Temperaturen sehr energie- und zeitaufwändig und damit kostenintensiv sind.

Darüber hinaus können die Synthesen nicht kontinuierlich, sondern nur chargenweise durchgeführt werden.

Aufgabe der vorliegenden Erfindung ist es, ein kostengünstigeres Verfahren zum Herstellen einer solchen anorganischen Verbindung der allgemeinen Formel $AXO_2$ anzugeben. Weitere Aufgaben der Erfindung bestehen darin, eine entsprechende anorganische Verbindung sowie Verwendungsmöglichkeiten für eine derartige anorganische Verbindung anzugeben.

Die Aufgaben werden erfindungsgemäß durch ein Verfahren mit den Merkmalen des Patentanspruchs 1, durch eine anorganische Verbindung gemäß Patentanspruch 9 sowie durch eine Verwendung gemäß Patentanspruch 15 gelöst. Vorteilhafte Ausgestaltungen mit zweckmäßigen Weiterbildungen der Erfindung sind in den jeweiligen Unteransprüchen angegeben, wobei vorteilhafte Ausgestaltungen jedes Erfindungsaspekts als vorteilhafte Ausgestaltungen der jeweils anderen Erfindungsaspekte und umgekehrt anzusehen sind.

Ein erster Aspekt der Erfindung betrifft ein Verfahren zum Herstellen einer anorganischen Verbindung der allgemeinen Formel $AXO_2$, in welcher A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind. Das erfindungsgemäße Verfahren umfasst zumindest die Schritte a) Bereitstellen einer wässrigen Lösung, die gelöste Kationen von A und X enthält, b) Einstellen einer Temperatur der wässrigen Lösung auf einen Wert von höchstens 95 °C, c) Einstellen eines pH-Werts der wässrigen Lösung auf einen Wert zwischen 0 und 14 unter Ausbildung von Fällungsprodukten und d) Alterung der Fällungsprodukte bei mindestens 35 °C und für mindestens 10 Minuten unter Ausbildung von $AXO_2$. Mit anderen Worten ist es erfindungsgemäß vorgesehen, dass die anorganische Verbindung der allgemeinen Formel $AXO_2$ durch eine Fällungsreaktion aus einer wässrigen Lösung der betreffenden Kationen von A und X bei vergleichsweise niedrigen Temperaturen von höchstens 95 °C mit anschließender Alterung des Niederschlags bzw. des oder der Fällungsprodukte hergestellt wird, wobei ein pH-Wert der wässrigen Lösung in Abhängigkeit der Kationen A und X - sofern erforderlich - eingestellt wird. Im Unterschied zum Stand der Technik ermöglicht das erfindungsgemäße Verfahren aufgrund der Kombination von Temperatur und Alkalisierung eine Reaktionsdurchführung bei vergleichsweise niedrigen Temperaturen von 95 °C oder weniger, und unter geringerem Zeitaufwand, wobei das Verfahren nicht nur chargenweise, sondern auch kontinuierlich durchführbar ist. Auch kann das erfindungsgemäße Verfahren vollständig in normalen, gegebenenfalls offenen Gefäßen unter Atmosphärengasen und -druck durchgeführt werden, so dass auf Autoklaven und andere druckstabile Gefäße vorteilhaft verzichtet werden kann. Unter einer Temperatur von 95 °C oder weniger sind im Rahmen der vorliegenden Erfindung Temperaturen von 95 °C, 94 °C, 93 °C, 92 °C, 91 °C, 90 °C, 89 °C, 88 °C, 87 °C, 86 °C, 85 °C, 84 °C, 83 °C, 82 °C, 81 °C, 80 °C, 79 °C, 78 °C, 77 °C, 76 °C, 75 °C, 74 °C, 73 °C, 72 °C, 71 °C, 70 °C, 69 °C, 68 °C, 67 °C, 66 °C, 65 °C, 64 °C, 63 °C, 62 °C, 61 °C, 60 °C, 59 °C, 58 °C, 57 °C, 56 °C, 55 °C, 54 °C, 53 °C, 52 °C, 51 °C, 50 °C, 49 °C, 48 °C, 47 °C, 46 °C, 45 °C, 44 °C, 43 °C, 42 °C, 41 °C, 40 °C, 39 °C, 38 °C, 37 °C, 36 °C, 35 °C, 34 °C, 33 °C, 32 °C, 31 °C, 30 °C, 29 °C, 28 °C, 27 °C, 26 °C, 25 °C, 24 °C, 23 °C, 22 °C, 21 °C, 20 °C, 19 °C, 18 °C, 17 °C, 16 °C, 15 °C, 14 °C, 13 °C, 12 °C, 11 °C, 10 °C oder weniger sowie entsprechende Zwischentemperaturen wie etwa 70,0 °C, 70,1 °C, 70,2 °C, 70,3 °C, 70,4 °C, 70,5 °C, 70,6 °C, 70,7 °C, 70,8 °C, 70,9 °C, 71,0 °C usw. zu verstehen. Temperaturen unter 10 °C sind zwar grundsätzlich denkbar, führen jedoch üblicherweise zu unwirtschaftlich langen Reaktionszeiten und geringen Ausbeuten an $AXO_2$. Die Temperatur kann dabei grundsätzlich konstant gehalten oder ein- oder mehrmals variiert werden. Entsprechend werden unter einem pH-Wert zwischen 0 und 14 Werte von 0, 0,1, 0,2, 0,3, 0,4, 0,5, 0,6, 0,7, 0,8, 0,9, 1,0, 1,1, 1,2, 1,3, 1,4, 1,5, 1,6, 1,7, 1,8, 1,9, 2,0, 2,1, 2,2, 2,3, 2,4, 2,5, 2,6, 2,7, 2,8, 2,9, 3,0, 3,1, 3,2, 3,3, 3,4, 3,5, 3,6, 3,7, 3,8, 3,9, 4,0, 4,1, 4,2, 4,3, 4,4, 4,5, 4,6, 4,7, 4,8, 4,9, 5,0, 5,1, 5,2, 5,3, 5,4, 5,5, 5,6, 5,7, 5,8, 5,9, 6,0, 6,1, 6,2, 6,3, 6,4, 6,5, 6,6, 6,7, 6,8, 6,9, 7,0, 7,1, 7,2, 7,3, 7,4, 7,5, 7,6, 7,7, 7,8, 7,9, 8,0, 8,1, 8,2, 8,3, 8,4, 8,5, 8,6, 8,7, 8,8, 8,9, 9,0, 9,1, 9,2, 9,3, 9,4, 9,5, 9,6, 9,7, 9,8, 9,9, 10,0, 10,1, 10,2, 10,3, 10,4, 10,5, 10,6, 10,7, 10,8, 10,9, 11,0, 11,1, 11,2, 11,3, 11,4, 11,5, 11,6, 11,7, 11,8, 11,9, 12,0, 12,1, 12,2, 12,3, 12,4, 12,5, 12,6, 12,7, 12,8, 12,9, 13,0, 13,1, 13,2, 13,3, 13,4, 13,5, 13,6, 13,7, 13,8, 13,9 oder 14,0 sowie entsprechende Zwischenwerte wie beispielsweise 10,90, 10,91, 10,92, 10,93, 10,94, 10,95, 10,96, 10,97, 10,98, 10,99, 11,00, 11,01, 11,02, 11,03, 11,04, 11,05, 11,06, 11,07, 11,08, 11,09, 11,10 usw. verstanden. A und X liegen im Endprodukt $AXO_2$ abhängig voneinander jeweils in einer der Oxidationsstufen +I, +II oder +III vor, wobei sich zumindest die mittleren Oxidationsstufen von A und X immer zu +IV ergänzen. Vorzugsweise besitzt A im Endprodukt die Oxidationsstufe +I, während X die Oxidationsstufe +III besitzt. Abhängig von den in Schritt a) bereitgestellten Kationen und deren Oxidationsstufen kann das Verfahren bzw. die Synthese von $AXO_2$ eine Redoxreaktion umfassen, beispielsweise wenn A und X in der wässrigen Lösung in Schritt a) jeweils in der Oxidationsstufe +II bereitgestellt werden oder vorliegen. Grundsätzlich wird das Verfahren aber vorzugsweise ohne Zusatz von externen Reduktionsmitteln, insbesondere ohne den Zusatz organischer Reduktionsmittel durchgeführt. Es versteht sich, dass insbesondere die Schritt b) und c) auch vertauscht, gleichzeitig durchgeführt und/oder ein- oder mehrmals wiederholt werden können. Beispielsweise kann Schritt c) zwei- oder mehrmals, also 2-, 3-, 4-, 5-, 6-, 7-, 8-, 9-, 10-Mal oder öfter durchgeführt werden, wobei die jeweils portionsweise zugegebenen Mengen gleiche oder unterschiedliche molare Konzentrationen an Säure/Base aufweisen können bzw. gleiche oder unterschiedliche Molalitäten aufweisen können. Ebenso kann eine tropfen- bzw. portionsweise Zugabe nach Art einer Titration vorgesehen sein. Alternativ oder zusätzlich ist auch eine kontinuierliche Zugabe von Säure/Base möglich, wobei die pro Zeiteinheit zugegebene Menge zeitlich konstant sein kann oder zeitlich variieren kann. Ebenso kann vorgesehen sein, dass der pH-Wert bis zum Ende der Reaktion konstant oder ein- oder mehrmals neu eingestellt, das heißt variiert wird. Die Einstellung eines neuen pH-Werts kann grundsätzlich graduell oder zumindest im Wesentlichen stufenartig erfolgen. Ebenso kann vorgesehen sein, dass Schritt c) nicht durchgeführt wird, wenn die bereitgestellte wässrige Lösung bereits den gewünschten pH-Wert besitzt. Weiterhin können in Schritt a) zunächst eine wässrige Lösung mit A und eine separate wässrige Lösung mit X bereitgestellt und erst nach Schritt a) vereinigt werden. Beispielsweise kann vorgesehen sein, dass in Schritt a) nur eine wässrigen Lösung, die gelöste Kationen von A oder X enthält, bereitgestellt wird und dass in Schritt c) eine wässrige Lösung, die komplementär X oder A enthält, zum Einstellen des pH-Werts zugegeben wird (z. B. LiOH). Unter einer wässrigen Lösung sind im Rahmen der vorliegenden Erfindung grundsätzlich verdünnte, konzentrierte, gesättigte und übersättigte wässrige Lösungen zu verstehen. In einigen Ausführungsformen kann zudem eine kürzere Alterungszeit als 10 Minuten ausreichen, beispielsweise 9 min, 8 min, 7 min, 6 min, 5 min, 4 min, 3 min, 2 min, 1 min oder weniger, einschließlich 0 min, bzw. die Alterung vollzieht sich während der weiteren Aufarbeitung oder Isolierung des Produkts, so dass keine zusätzliche Zeit für die Alterung vorgesehen werden muss. Generell sind "ein/eine" im Rahmen dieser Offenbarung als unbestimmte und als bestimmte Artikel zu lesen, umfassen also ohne ausdrückliche spezifische Angabe sowohl "nur ein/nur eine" als auch "mindestens ein/mindestens eine".

Eine besonders hohe Ausbeute an $AXO_2$ kann in einer vorteilhaften Ausgestaltung der Erfindung dadurch erreicht werden, dass X ausgewählt wird aus der Gruppe Mg, Y, Fe, Mn, Cr, Co, Ni, Zn, Al, Ga, Sn, Au, Rh, In und Sc. Mit anderen Worten ist X ein von A verschiedenes Element oder mehrere, jeweils von A verschiedene Elemente aus der Gruppe Mg, Y, Fe, Mn, Cr, Co, Ni, Zn, Al, Ga, Sn, Au, Rh, In und Sc.

Weitere Vorteile ergeben sich, indem in Schritt a) ein Molverhältnis von A:X auf einen Wert zwischen 0,9 und 1,1 eingestellt wird und/oder dass eine Konzentration der Kationen von A und/oder X in Schritt a) auf mindestens 1 g/l eingestellt wird. Unter einem Molverhältnis von A:X zwischen 0,9 und 1,1 werden insbesondere Molverhältnisse von 0,90, 0,91, 0,92, 0,93, 0,94, 0,95, 0,96, 0,97, 0,98, 0,99, 1,00, 1,01, 1,02, 1,03, 1,04, 1,05, 1,06, 1,07, 1,08, 1,09 oder 1,10 sowie entsprechende Zwischenwerte verstanden. Eine Konzentration von mindestens 1 g/l umfasst beispielsweise Konzentrationen von 1 g/l, 2 g/l, 3 g/l, 4 g/l, 5 g/l, 6 g/l, 7 g/l, 8 g/l, 9 g/l, 10 g/l, 11 g/l, 12 g/l, 13 g/l, 14 g/l, 15 g/l, 16 g/l, 17 g/l, 18 g/l, 19 g/l, 20 g/l, 21 g/l, 22 g/l, 23 g/l, 24 g/l, 25 g/l, 26 g/l, 27 g/l, 28 g/l, 29 g/l, 30 g/l, 31 g/l, 32 g/l, 33 g/l, 34 g/l, 35 g/l, 36 g/l, 37 g/l, 38 g/l, 39 g/l, 40 g/l, 41 g/l, 42 g/l, 43 g/l, 44 g/l, 45 g/l, 46 g/l, 47 g/l, 48 g/l, 49 g/l, 50 g/l oder mehr. Die Konzentration kann auch so gewählt werden, dass die wässrige Lösung mit den betreffenden Kationen gesättigt oder übersättigt ist.

Weitere Vorteile ergeben sich, indem in Schritt a) eine wässrige Lösung bereitgestellt wird, welche Anionen umfasst, die aus der Gruppe $Cl^-$, $CO_3^{2-}$, $NO_3^-$ und $SO_4^{2-}$ ausgewählt sind. Hierdurch können insbesondere in Abhängigkeit von A unterschiedliche Löslichkeitswerte sowie Eigenheiten der jeweiligen Reaktionsführung optimal berücksichtigt werden. Beispielsweise können in Schritt a) sowohl A als auch X als Sulfate bereitgestellt werden. Ebenso kann vorgesehen sein, dass A und/oder X zusammen mit zwei oder mehr unterschiedlichen Gegenionen verwendet werden. Beispielsweise kann eine Mischung von $ANO_3$ und $XSO_4$ oder umgekehrt verwendet werden. Weiterhin kann vorgesehen sein, dass die in Schritt a) bereitgestellte wässrige Lösung neben A und X weitere Kationen und/oder weitere Anionen enthält, was beispielsweise bei der Verwendung von Abwässern normalerweise der Fall ist. Dies erlaubt eine gezielte Einstellung sowohl des Syntheseverlaufs als auch der Eigenschaften der resultierenden Verbindung $AXO_2$. Weiterhin kann $AXO_2$ als Speichermaterial für die weiteren Kationen und/oder Anionen ausgebildet werden, was beispielsweise bei der Abwasserbehandlung oder bei der Herstellung von Energiespeichern von Vorteil ist.

In einer weiteren vorteilhaften Ausgestaltung der Erfindung ist vorgesehen, dass die Temperatur in Schritt b) auf einen Wert zwischen 20 °C und 75 °C eingestellt wird. Hierdurch kann auf aufwändige Apparaturen und Sicherheitsmaßnahmen zur Durchführung des Verfahrens verzichtet und das Verfahren besonders einfach, das heißt insbesondere unter nicht-hydrothermalen Bedingungen durchgeführt werden. Zusätzlich sinkt auch der Energiebedarf. Weiterhin kann das Verfahren unter diesen Bedingungen besonders einfach kontinuierlich durchgeführt werden, wodurch weitere Kostensenkungen ermöglicht sind. Insbesondere Temperaturen zwischen 68 °C und 72 °C, also beispielsweise 70 °C, haben sich dabei als vorteilhaft gezeigt, um eine besonders hohe Ausbeute an reinphasigem $AXO_2$ mit hohen Reaktionsgeschwindigkeiten zu erzielen.

In einer weiteren vorteilhaften Ausgestaltung der Erfindung ist vorgesehen, dass zumindest einer der Schritte a), b), c) und d) unter einem Druck von höchstens 1,4 bar, insbesondere unter Atmosphärendruck durchgeführt werden. Unter einem Druck von höchstens 1,4 bar sind dabei im Rahmen der Erfindung Drücke von 1,40 bar, 1,30 bar, 1,20 bar, 1,10 bar, 1,00 bar, 900 mbar, 850 mbar, 800 mbar, 750 mbar, 700 mbar, 650 mbar, 600 mbar, 550 mbar, 500 mbar, 450 mbar, 400 mbar, 350 mbar, 300 mbar, 250 mbar, 200 mbar, 150 mbar, 100 mbar, 50 mbar oder weniger sowie entsprechende Zwischenwerte zu verstehen. Vorzugsweise wird das Verfahren unter Atmosphärendruck, das heißt üblicherweise bei Drücken zwischen etwa 900 mbar und 1,1 bar durchgeführt. Auch dies vereinfacht und verbilligt die Verfahrensdurchführung erheblich, da auf die Verwendung von Autoklaven, geschlossene bzw. gasdichte Druckbehälter, Druckleitungen oder dergleichen vorteilhaft verzichtet werden kann.

In weiterer Ausgestaltung der Erfindung wird der pH-Wert in Schritt c) durch vorzugsweise mehrfache Zugabe von Hydroxid-Ionen, insbesondere durch Alkalihydroxid und/oder Alkalilauge eingestellt. Dies stellt eine einfache und kostengünstige Möglichkeit zum schnellen und präzisen Einstellen des gewünschten pH-Werts dar. Unter Alkalihydroxid sind dabei insbesondere die Hydroxide von Lithium, Natrium und Kalium zu verstehen, wobei grundsätzlich auch die Hydroxide der weiteren Alkalimetalle vorgesehen sein können. Unter Alkalilauge wird im Rahmen der Erfindung eine wässrige Lösung eines oder mehrerer dieser Alkalihydroxide verstanden, die Zugabe von festem Alkalihydroxid wird jedoch nicht ausgeschlossen. Die Verwendung von Alkalilauge bietet gegenüber der Verwendung der festen Alkalihydroxide den Vorteil einer einfacheren und schnelleren Dosierung, wodurch eine entsprechend schnellere Einstellung des pH-Werts möglich ist. Vorzugsweise ist die Alkalilauge möglichst konzentriert bzw. gesättigt und besitzt einen AlkalihydroxidMassenanteil von mindestens 16 Gew.-%, vorzugsweise von mindestens 32 Gew.-%, um mit möglichst geringen Zugabemengen eine möglichst schnelle pH-Wert-Einstellung zu erzielen. Alternativ oder zusätzlich wird der pH-Wert in Schritt d) durch vorzugsweise mehrfache Zugabe einer Säure, insbesondere einer Mineralsäure aus der Gruppe HCl, $HNO_3$ und $H_2SO_4$ eingestellt. Auch dies erlaubt eine schnelle und präzise Einstellung. Indem eine Mineralsäure aus der Gruppe HCl, $HNO_3$ und $H_2SO_4$ verwendet wird, ist zudem sichergestellt, dass für die Reaktionsdurchführung kompatible Anionen in die wässrige Lösung eingebracht werden. Eine mehrfache bzw. kontinuierliche Zugabe kann über einen vorbestimmten Zeitraum, beispielsweise über 1, 2, 3, 4, 5, 6, 7, 8, 9, 10, 11, 12, 13, 14, 15, 16, 17, 18, 19, 20 Minuten oder länger, und/oder in Abhängigkeit einer Differenz zwischen einem Ist- und einem Ziel-pH-Wert erfolgen.

Eine Steigerung der Ausbeute an $AXO_2$ wird in weiterer Ausgestaltung der Erfindung dadurch erreicht, dass die Fällungsprodukte in Schritt d) mindestens 10 Minuten und/oder unter Luftabschluss altern. Unter einer Alterung von mindestens 10 Minuten sind dabei insbesondere 10, 11, 12, 13, 14, 15, 16, 17, 18, 19, 20, 21, 22, 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59 oder 60 Minuten sowie 2, 3, 4, 5, 6, 7, 8, 9, 10, 11, 12, 13, 14, 15, 16, 17, 18, 19, 20, 21, 22, 23, 24, 25, 26, 27, 28, 29, 30,31,32,33,34,35,36,37,38,39,40,41,42,43,44,45,46,47,48,49,50,51, 52, 53, 54, 55, 56, 57, 58, 59, 60, 61, 62, 63, 64, 65, 66, 67, 68, 69, 70, 71, 72 Stunden oder mehr zu verstehen. Ebenso kann die Alterung unter Luftabschluss bzw. unter Ausschluss von Sauerstoff durchgeführt werden. Luftabschluss kann beispielsweise durch Verwendung eines zumindest im Wesentlichen gasdicht geschlossenen Behälters erreicht werden. Ebenso kann vorgesehen sein, dass die Fällungsprodukte durch Schutzgasbeaufschlagung mit Stickstoff, Argon oder dergleichen vor dem Zutritt von Sauerstoff geschützt werden.

In einer weiteren vorteilhaften Ausgestaltung der Erfindung altern die Fällungsprodukte in Schritt d) in wässriger Umgebung, wobei ein pH-Wert der wässrigen Umgebung vorzugsweise wenigstens einmal auf einen vorbestimmten Mindestwert eingestellt und/ für eine vorbestimmte Zeitdauer auf einem vorbestimmten Mindestwert gehalten wird. Der Mindestwert kann grundsätzlich ebenfalls zwischen 0 und 14 betragen, wobei Werte von mindestens 10 in der Regel bevorzugt sind. Auch diese Maßnahme verbessert die Ausbeute an $AXO_2$ und dessen Reinphasigkeit. Dabei kann grundsätzlich vorgesehen sein, dass der pH-Wert während eines bestimmten Zeitabschnitts der Alterung, beispielsweise zu Beginn der Alterung oder gegen Ende der Alterung, oder während der gesamten Alterung kontrolliert und gegebenenfalls neu eingestellt bzw. auf oder über einem Mindestwert gehalten wird. Als wässrige Umgebung kann beispielsweise die ursprüngliche wässrige Lösung bzw. der Überstand der Fällungsreaktion verwendet werden. Alternativ oder zusätzlich kann grundsätzlich vorgesehen sein, dass die Fällungsprodukte zunächst vom Überstand abgetrennt, gegebenenfalls gewaschen und anschließend in einer kontrollierten wässrigen Umgebung gealtert werden. Alternativ oder zusätzlich wird die Temperatur in Schritt d) derart kontrolliert, dass die Fällungsprodukte bei einer Temperatur zwischen 10 °C und 99 °C, das heißt bei 10 °C, 11 °C, 12 °C, 13 °C, 14 °C, 15 °C, 16 °C, 17 °C, 18 °C, 19 °C, 20 °C, 21 °C, 22 °C, 23 °C, 24 °C, 25 °C, 26 °C, 27 °C, 28 °C, 29 °C, 30 °C, 31 °C, 32 °C, 33 °C, 34 °C, 35 °C, 36 °C, 37 °C, 38 °C, 39 °C, 40 °C, 41 °C, 42 °C, 43 °C, 44 °C, 45 °C, 46 °C, 47 °C, 48 °C, 49 °C, 50 °C, 51 °C, 52 °C, 53 °C, 54 °C, 55 °C, 56 °C, 57 °C, 58 °C, 59 °C, 60 °C, 61 °C, 62 °C, 63 °C, 64 °C, 65 °C, 66 °C, 67 °C, 68 °C, 69 °C, 70 °C, 71 °C, 72 °C, 73 °C, 74 °C, 75 °C, 76 °C, 77 °C, 78 °C, 79 °C, 80 °C, 81 °C, 82 °C, 83 °C, 84 °C, 85 °C, 86 °C, 87 °C, 88 °C, 89 °C, 90 °C, 91 °C, 92 °C, 93 °C, 94 °C, 95 °C, 96 °C, 97 °C, 98 °C oder 99 °C altern. Auch hier kann vorgesehen sein, dass die Temperatur während der Alterung konstant gehalten oder ein- oder mehrfach im angegebenen Bereich variiert wird.

In einer weiteren vorteilhaften Ausgestaltung der Erfindung wird Schritt d) abgebrochen, sobald ein mittlerer Partikeldurchmesser der anorganischen Verbindung der Formel $AXO_2$ 1000 nm beträgt oder übersteigt und/oder sobald eine mittlere Partikeldicke der anorganischen Verbindung der Formel $AXO_2$ 50 nm beträgt oder übersteigt. Unter einem mittleren Partikeldurchmesser von höchstens 1000 nm sind insbesondere mittlere Partikeldurchmesser von 1000 nm, 990 nm, 980 nm, 970 nm, 960 nm, 950 nm, 940 nm, 930 nm, 920 nm, 910 nm, 900 nm, 890 nm, 880 nm, 870 nm, 860 nm, 850 nm, 840 nm, 830 nm, 820 nm, 810 nm, 800 nm, 790 nm, 780 nm, 770 nm, 760 nm, 750 nm, 740 nm, 730 nm, 720 nm, 710 nm, 700 nm, 690 nm, 680 nm, 670 nm, 660 nm, 650 nm, 640 nm, 630 nm, 620 nm, 610 nm, 600 nm, 590 nm, 580 nm, 570 nm, 560 nm, 550 nm, 540 nm, 530 nm, 520 nm, 510 nm, 500 nm, 490 nm, 480 nm, 470 nm, 460 nm, 450 nm, 440 nm, 430 nm, 420 nm, 410 nm, 400 nm, 390 nm, 380 nm, 370 nm, 360 nm, 350 nm, 340 nm, 330 nm, 320 nm, 310 nm, 300 nm, 290 nm, 280 nm, 270 nm, 260 nm, 250 nm, 240 nm, 230 nm, 220 nm, 210 nm, 200 nm, 190 nm, 180 nm, 170 nm, 160 nm, 150 nm, 140 nm, 130 nm, 120 nm, 110 nm, 100 nm, 90 nm, 80 nm, 70 nm, 60 nm, 50 nm, 40 nm, 30 nm, 20 nm, 10 nm, 9 nm, 8 nm, 7 nm, 6 nm, 5 nm, 4 nm, 3 nm, 2 nm, 1 nm oder kleiner zu verstehen. Unter einer mittleren Partikeldicke von höchstens 50 nm sind dementsprechend mittlere Partikeldicken von 50 nm, 49 nm, 48 nm, 47 nm, 46 nm, 45 nm, 44 nm, 43 nm, 42 nm, 41 nm, 40 nm, 39 nm, 38 nm, 37 nm, 36 nm, 35 nm, 34 nm, 33 nm, 32 nm, 31 nm, 30 nm, 29 nm, 28 nm, 27 nm, 26 nm, 25 nm, 24 nm, 23 nm, 22 nm, 21 nm, 20 nm, 19 nm, 18 nm, 17 nm, 16 nm, 15 nm, 14 nm, 13 nm, 12 nm, 11 nm, 10 nm, 9 nm, 8 nm, 7 nm, 6 nm, 5 nm, 4 nm, 3 nm, 2 nm, 1 nm oder weniger zu verstehen. Hierdurch kann eine besonders vorteilhafte nanoskalige Partikelgrößenverteilung erreicht werden, die beispielsweise durch die aus dem Stand der Technik bekannten hydrothermalen Verfahren nicht möglich ist, da diese lediglich mikroskalige Partikel erzeugen können. Aufgrund der spezifischen Partikelgrößen und -dicken besitzt die Verbindung $AXO_2$ einerseits eine hohe spezifische Oberfläche und andererseits für viele Anwendungen vorteilhafte Oberflächeneigenschaften, veränderte magnetische Eigenschaften etc., die bislang nicht oder nur durch aufwändige Nachbearbeitungsschritte und Mahlverfahren zugänglich waren.

Weitere Vorteile ergeben sich, wenn die anorganische Verbindung der Formel $AXO_2$ nach Schritt d) isoliert und/oder aufgearbeitet wird. Hierdurch kann die Verbindung optimal für eine anschließende Anwendung bereitgestellt bzw. aufbereitet werden.

Weitere Vorteile ergeben sich, wenn in Schritt a) als wässrige Lösung ein Abwasser, insbesondere ein Metallionen-haltiges Industrieabwasser verwendet wird. Hierdurch ist eine praktisch vollständige Entfernung von A und/oder X Kationen aus dem betreffenden Abwasser ermöglicht. Je nach Zusammensetzung des Abwassers kann A und/oder X dabei gegebenenfalls in löslicher Form zugegeben werden, beispielsweise um ein gewünschtes Molverhältnis einzustellen. Damit kann das erfindungsgemäße Verfahren vorteilhaft zur Abwasseraufbereitung verwendet werden, wobei gleichzeitig $AXO_2$ als wertvolles Produkt gewonnen wird. Eventuelle sich zusätzlich in der wässrigen Lösung befindenden Kationen können mitgefällt, in die Kristallstruktur eingebaut bzw. adsorptiv während des Herstellungsverfahrens an das Produkt gebunden werden.

Ein zweiter Aspekt der Erfindung betrifft eine anorganischen Verbindung der allgemeinen Formel $AXO_2$, in welcher A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind, wobei die anorganische Verbindung erhältlich und/oder erhalten durch ein Verfahren gemäß dem ersten Erfindungsaspekt ist. Die sich hieraus ergebenden Merkmale und deren Vorteile sind den Beschreibungen des ersten Erfindungsaspekts zu entnehmen, wobei vorteilhafte Ausgestaltungen des ersten Erfindungsaspekts als vorteilhafte Ausgestaltungen des zweiten Erfindungsaspekts und umgekehrt anzusehen sind.

In einer vorteilhaften Ausgestaltung der Erfindung ist vorgesehen, dass $AXO_2$ eine Delafossit-Struktur besitzt.

Die Delafossit-Struktur weist grundsätzlich eine $P\frac{6_3}{m}mc$ (hexagonale) und eine $R\overline{3}m$ (rhomboedrische) Raumgruppe auf. In Abhängigkeit der Schichtstapel können dabei hexagonale 2H (ABABAB) und/oder trigonale 3R (ABCABC) Polytypen vorgesehen sein, wobei eine reinphasige Zusammensetzung grundsätzlich bevorzugt ist. Weitere Vorteile ergeben sich, indem die anorganische Verbindung als Partikel mit einem mittleren Partikeldurchmesser von höchstens 1000 nm und/oder mit einer mittleren Partikeldicke von höchstens 50 nm vorliegt. Insbesondere sind die Partikel plättchenförmig. Hierdurch ist die anorganische Verbindung erstmals für verschiedene Anwendungen geeignet, die zuvor aufgrund der zu großen Partikelgrößen nicht möglich waren.

Weitere Vorteile ergeben sich, indem $AXO_2$ die Formel $AgFeO_2$, $CdFeO_2$, $PdFeO_2$, $PtFeO_2$, $AuFeO_2$, $LiFeO_2$, $CuFeO_2$, $CuCrO_2$, $CuNiO_2$, $AgCrO_2$, $CuMnO_2$, $PdFeO_2$, $PdCrO_2$, $PdMnO_2$, $PdCoO_2$, $PtCoO_2$, $CuInO_2$, $CuYO_2$, $CuAlO_2$, $CuGaO_2$, $AgNiO_2$, $A\text{-}glnO_2$, $PdCoO_2$, $CuCoO_2$, $AgFeO_2$, $PtCoO_2$, $LiCoO_2$, $AgCoO_2$, $CuLaO_2$, $LiNiO_2$, $LiM\text{-}nO_2$, $AgAlO_2$, $LiMnO_2$ oder $CuSnO_2$ besitzt. Diese Verbindungen besitzen unter anderem vorteilhafte magnetische, optische, elektrische und antimikrobielle Eigenschaften und eignen sich aufgrund ihrer Transparenz und ihrer geringen Toxizität für zahlreiche Anwendungen, beispielsweise für die Photovoltaik bzw. zur Herstellung von Solarzellen oder als spintronisches Speichermaterial.

In einer vorteilhaften Ausgestaltung der Erfindung ist vorgesehen, dass A mehrere Elemente $A^n$ mit $2 \leq n \leq 6$ aus der Gruppe Cu, Ag, Pd, Pt, Au, Na und Li umfasst und/oder dass X mehrere metallische Elemente $X^m$ mit $m \geq 2$ aus der Gruppe der Übergangsmetalle, der Leichtmetalle, der Seltenerdmetalle und/oder des p-Blocks umfasst. Die Buchstaben n und m stellen dabei keine Oxidationsstufen, sondern Indizes dar. Mit anderen Worten umfassen A und/oder X mindestens zwei Elemente aus ihrer jeweils angegebenen Gruppe, wobei sich die Anteile aller $A^n$ an A bzw. aller $X^m$ an X immer zu 1 ergänzen und der Summenformel $(A^1/A^2/ \dots A^n)_1(X^1/X^2/ \dots X^m)_1 O_2$ entsprechen.

Dementsprechend kann in weiterer Ausgestaltung der Erfindung vorgesehen sein, dass die anorganische Verbindung eine Mischverbindung der Formel $Li(Mn, Ni, Co)O_2$, $Cu(Fe_{1-x}Cr_x)O_2$, $Cu(Fe_{1-x}Mn_x)O_2$, $(Cu_xPd_{x-1})FeO_2$, $CuFe_{1-x}Sn_xO_2$, $CuCr_{1-x}Mg_xO_2$, $CuFe_{1-x}Al_xO_2$, $CuCr_{1-x}Mg_xO_2$ oder $CuCr_{1-x}Ni_xO_2$ mit $0<x<1$ ist. Der Index x kann daher beispielsweise 0,05, 0,10, 0,15, 0,20, 0,25, 0,30, 0,35, 0,40, 0,45, 0,50, 0,55, 0,60, 0,65, 0,70, 0,75, 0,80, 0,85, 0,90 oder 0,95 betragen, wobei beliebige Zwischenwerte vorgesehen sein können. Der Index x kann beispielsweise durch entsprechende Wahl des molaren Verhältnisses von $A^1:A^2$ bzw. $X^1:X^2$ in Schritt a) eingestellt werden. In der Verbindung $Li(Mn, Ni, Co)O_2$ ergänzen sich die molaren Anteile von Mn, Ni und Co ebenfalls zu 1, wobei ein oder zwei der genannten Elemente auch einen Anteil von Null aufweisen können, so dass unter diese allgemeine Formel auch die Verbindungen $LiMnO_2$, $LiNiO_2$, $LiCoO_2$, $Li(Mn, Ni)O_2$, $Li(Mn, Co)O_2$ usw. fallen. Insofern kann die Verbindung auch durch die Formel $Li(Mn_x, Ni_y, Co_z)O_2$ repräsentiert werden, in welcher gilt:

$$0 \leq x \leq 1;$$

$$0 \leq y \leq 1;$$

$$0 \leq z \leq 1;$$

und

$$x+y+z=1.$$

Weitere Vorteile ergeben sich, indem die anorganische Verbindung mit wenigstens einem Element, das aus der Gruppe As und Li ausgewählt ist, und/oder mit wenigstens einem radiaktiven Element mit einer Ordnungszahl $\geq 55$, insbesondere mit einem oder mehreren Elementen aus der Gruppe Jod, Cäsium, Strontium, Uran und/oder Plutonium, dotiert ist. Hierdurch kann die anorganische Verbindung in Abhängigkeit von ihrem jeweiligen Verwendungszweck beispielsweise zur Reinigung von mit Arsen oder radioaktiven Elementen belasteten Wässern, beispielsweise nach Kernkraftwerks- oder Lagerstättenhavarien, oder als Speicher für Li-Ionen, beispielsweise im Rahmen von Energiespeicherelementen verwendet werden.

Ein dritter Aspekt der Erfindung betrifft die Verwendung einer anorganischen Verbindung der allgemeinen Formel $AXO_2$, in welcher A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind, als Katalysator und/oder als photochemisches und/oder elektrochemisches und/oder antimikrobiell wirksames Material und/oder als Speichermaterial für toxische und/oder radioaktive Elemente und/oder zur Reinigung von Abwässern und/oder zur Herstellung von Solarzellen und/oder als Spintronik-Werkstoff, insbesondere als spintronischer Speicher, wobei die anorganische Verbindung durch ein Verfahren gemäß dem ersten Erfindungsaspekt erhältlich und/oder erhalten ist und/oder gemäß dem zweiten Erfindungsaspekt ausgebildet ist. Die sich hieraus ergebenden Merkmale und deren Vorteile sind den Beschreibungen des ersten und des zweiten Erfindungsaspekts zu entnehmen, wobei vorteilhafte Ausgestaltungen des ersten und zweiten Erfindungsaspekts als vorteilhafte Ausgestaltungen des dritten Erfindungsaspekts und umgekehrt anzusehen sind.

Weitere Merkmale der Erfindung ergeben sich aus den Ansprüchen und den Ausführungsbeispielen. Die vorstehend in der Beschreibung genannten Merkmale und Merkmalskombinationen, sowie die nachfolgend in den Ausführungsbeispielen genannten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als umfasst und offenbart anzusehen, die in den Ausführungsbeispielen nicht explizit erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen und die folgenden Ausführungsbeispiele, als offenbart anzusehen, die über die in den Rückbezügen der Ansprüche dargelegten Merkmalskombinationen hinausgehen oder von diesen abweichen.

Die Erfindung betrifft Fällungsreaktionen mit anschließender Alterung der Fällungsprodukte zur Synthese von anorganischen Verbindungen der allgemeinen Formel $AXO_2$ bei niedrigen Temperaturen von maximal 95 °C. Dabei bedeutet A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks. Die Fällungsreaktion verläuft beispielsweise bei Temperaturen zwischen 35 °C und 95 °C unter Atmosphärendruck und kann grundsätzlich kontinuierlich oder chargenweise durchgeführt werden. Die anschließende Alterung von zumindest einem Teil der Lösung und den enthaltenen Feststoffen bzw. Fällungsprodukten für zumindest 10 Minuten kann sowohl in einem offenen als auch in einem geschlossenen System bei Temperaturen zwischen 35 °C und beispielsweise 95 °C erfolgen. Generell kann die Alterungszeit in einigen Fällen auch kürzer als 10 Minuten sein. Ebenso kann eine Alterung im Rahmen eines nachfolgenden Aufarbeitungs- und/oder Isolierungsschritts vorgenommen werden. Weiterhin kann in einigen Fällen auf eine Alterung auch vollständig verzichtet werden. Die Zugabe eines externen Reduktionsmittels, insbesondere eines organischen Reduktionsmittels ist dabei grundsätzlich nicht notwendig.

Als Basis für die Reaktion dienen generell metallhaltige (Kationen von A und X aus einem oder mehreren Elementen der genannten Gruppen, beispielsweise Cu, Zn, Cr, Ag, Ni, Fe usw.) wässrige Lösungen, die als Gegenionen insbesondere Chlorid, Carbonat, Nitrat und/oder Sulfat enthalten. Die Verwendung von Sulfaten bietet dabei den Vorteil, dass die entsprechenden Salze von A und X generell ausreichend gut wasserlöslich sind. Der pH-Wert dieser wässrigen Lösung wird - sofern erforderlich - auf einen vorbestimmten Wert eingestellt und auf eine Temperatur bis 95 °C temperiert. Anschließend werden die gebildeten Rückstände bzw. Fällungsprodukte ein- oder mehrmals mit Wasser gewaschen, um Fremdphasen wie z.B. Natrium- bzw. Schwefelreste zu entfernen.

Beispiel 1:

Herstellung von $CuFeO_2$ (Delafossit)

Es wurden $FeSO_4*7\ H_2O$ und $CuSO_4*5\ H_2O$ mit einer $Cu^{2+}$-Konzentration von 10 g/L in Wasser gelöst. Das Molverhältnis von Kupfer zu Eisen entsprach etwa 1:1. Eine Alkalisierung auf einen pH-Wert von etwa 11 wurde innerhalb von 30 Sekunden durch Zugabe entsprechender Mengen von 32%iger NaOH-Lauge durchführt. Die Reaktionstemperatur betrug 70 °C. Die Rückstände bzw. Fällungsprodukte wurden anschließend bei 70 °C im offenen oder geschlossenen Behälter (kein Unterschied für erzieltes Produkt) für mindestens 10 h gealtert. Der pH-Wert der Fällungsprodukte bzw. der wässrigen Umgebung, in welcher die Fällungsprodukte gealtert wurden, wurde durch Zugabe von Natronlauge für 5 Minuten auf oder über pH 10 gehalten. In den frischen (nicht gealterten) Fällungsprodukten wurde mindestens eine prozesswirksame Phase, insbesondere Grüner Rost festgestellt, der als Reduktionsmittel wirkte. Der Bildung des Delafossites gingen mehrere Zwischenphasen wie z.B. Cuprit und Ferrihydrite voraus. Die nach dem Erreichen des pH-Wertes gemessene Konzentration von Kupfer bzw. Eisen in der Lösung lag zwischen 0,5 und 2 mg/l. Das bedeutet, dass durch den Prozess mindestens 99,98 % des Kupfers und Eisens aus der verwendeten wässrigen Lösung entfernt wurden.

Als Reduktionsmittel dient vermutlich der sich aufgrund der erfindungsgemäßen Kombination von Temperierung und Alkalisierung *in situ* aus den Fe-Kationen bildende grüne Rost. Unter grünem Rost werden intermediäre Phasen verstanden, die planare, positiv geladene, trioktaedrische Fe(II)-Fe(III)-Hydroxidschichten umfassen, welche durch hydratisierte Anionen in den Zwischenschichten ausgeglichen werden. Die allgemeine Formel von grünem Rost lautet:

$$[Fe(II)_{(6-x)}Fe(III)_x(OH)_{12}]^{x+}[(D)_{x/n}*y\ H_2O]^{x-},$$

mit:

x = 0,9 bis 4,2;
D = n-valente Anionen (z. B. $CO_3^{2-}$, $Cl^-$ oder $SO_4^{2-}$); und

y = Anzahl der Wassermoleküle in der Zwischenschicht.

Ohne auf diese Hypothese festgelegt werden zu wollen, gehen die Erfinder davon aus, dass sich das Produkt $CuFeO_2$ während der Alterung des oder der Niederschläge bzw. Fällungsprodukte in Schritt d) über die Zwischenstufe der prozesswirksamen Phase "grüner Rost" sowie gegebenenfalls über eine oder mehrere weitere instabile Zwischenstufen bildet, bei denen es sich vorwiegend um Ferrihydrite handeln dürfte. Daher ist das Altern von mindestens 10 Minuten in Schritt d) von Vorteil, um eine möglichst hohe Ausbeute an reinphasigem $CuFeO_2$ zu erhalten, obwohl sich $CuFeO_2$ natürlich auch schon zu früheren Zeitpunkten bildet.

Der derart hergestellte $CuFeO_2$ besteht aus reinphasigen, plättchenförmigen, hexagonalen Partikeln mit einer relativ homogenen Korngrößenverteilung mit durchschnittlichen Partikeldurchmessern im Bereich von 300 nm Durchmesser und etwa 15-17 nm Dicke. Je nach Reaktionsführung sind auch Durchmesser unter 100 nm und Dicken von 5 nm oder weniger möglich.

Beispiel 2:

Das oben beschriebene Verfahren wurde in analoger Weise mit weiteren Elementen A und X durchgeführt. Auf diese Weise wurden die entsprechende anorganische Verbindungen $AgFeO_2$, $CdFeO_2$, $PdFeO_2$, $PtFeO_2$, $AuFeO_2$, $LiFeO_2$, $CuFeO_2$, $CuC-rO_2$, $CuNiO_2$, $AgCrO_2$, $CuMnO_2$, $PdFeO_2$, $PdCrO_2$, $PdMnO_2$, $PdCoO_2$, $PtCoO_2$, $CuInO_2$, $CuYO_2$, $CuAlO_2$, $CuGaO_2$, $AgNiO_2$, $AgInO_2$, $PdCoO_2$, $CuCoO_2$, $AgFeO_2$, $PtCoO_2$, $LiCoO_2$, $AgCoO_2$, $CuLaO_2$, $LiNiO_2$, $LiMnO_2$, $Li(Mn, Ni, Co)O_2$, $AgAlO_2$ und $CuSnO_2$ erhalten. Auch diese Verbindungen wiesen die vorstehend genannten Vorteile im Hinblick auf eine spezifische Partikelgrößenverteilung sowie im Hinblick auf spezielle magnetische, optische, elektrische und antimikrobielle Eigenschaften auf.

Beispiel 3:

Herstellung von $CuCrO_2$

Das Herstellungsverfahren wurde grundsätzlich analog zum ersten Ausführungsbeispiel durchgeführt. Als Edukte wurden $Cu(II)SO_4*5 H_2O$ und $Cr(II)SO_4*5 H_2O$ in wässriger Lösung verwendet. Der pH-Wert der Lösung wurde auf einen Wert >9 eingestellt, während die Temperatur der Lösung auf etwa 80 °C eingestellt wurde. Nach dem Abtrennen und einer Alterung der Fällungsprodukte über etwa 10 Stunden wurde $CuCrO_2$ als reine Phase erhalten.

Beispiel 4:

Herstellung von $Cu(Fe_{1-x}Cr_x)O_2$ mit 0<x<1:

Das Herstellungsverfahren wurde grundsätzlich analog zum ersten Ausführungsbeispiel durchgeführt. Als Edukte wurden $Cu(II)SO_4*5 H_2O$, $FeSO_4*7 H_2O$ und $Cr(II)SO_4*5 H_2O$ in wässriger Lösung verwendet. Der pH-Wert der Lösung wurde auf einen Wert >10 eingestellt, während die Temperatur der Lösung auf etwa 70 °C eingestellt wurde. Nach dem Abtrennen und einer Alterung der Fällungsprodukte über etwa 10 Stunden wurde $Cu(Fe_{1-x}Cr_x)O_2$ als reine Phase erhalten. Der Index x kann durch entsprechende Wahl des eingesetzten molaren Verhältnisses von Fe:Cr frei variiert werden. Der Index x kann daher beispielsweise 0,05, 0,10, 0,15, 0,20, 0,25, 0,30, 0,35, 0,40, 0,45, 0,50, 0,55, 0,60, 0,65, 0,70, 0,75, 0,80, 0,85, 0,90 oder 0,95 betragen, wobei beliebige Zwischenwerte vorgesehen sein können.

Beispiel 5:

Herstellung von $AgCrO_2$:

Das Herstellungsverfahren wurde grundsätzlich analog zum ersten Ausführungsbeispiel durchgeführt. Als Edukte wurden $Ag_2SO_4$ und $Cr(III)_2(SO_4)_3$ in wässriger Lösung verwendet. Der pH-Wert der Lösung wurde durch Säurezugabe auf einen Wert von mindestens 3 eingestellt, während die Temperatur der Lösung auf etwa 70 °C eingestellt wurde. Nach dem Abtrennen und einer Alterung der Fällungsprodukte über etwa 4 Stunden wurde $AgCrO_2$ als reine Phase erhalten.

Beispiel 6:

Herstellung von $Cu(Fe_{1-x}Mn_x)O_2$ mit 0<x<1:

Das Herstellungsverfahren wurde grundsätzlich analog zum ersten Ausführungsbeispiel durchgeführt. Als Edukte wurden $MnSO_4$, $Fe(II)SO_4*7\,H_2O$ und $Cu(II)SO_4*5\,H_2O$ in wässriger Lösung verwendet. Der pH-Wert der Lösung wurde auf einen Wert von etwa 11 eingestellt, während die Temperatur der Lösung auf etwa 60 °C eingestellt wurde. Nach dem Abtrennen und einer Alterung der Fällungsprodukte über etwa 8 Stunden wurde $Cu(Fe_{1-x}Mn_x)O_2$ als reine Phase erhalten. Der Index x kann durch entsprechende Wahl des eingesetzten molaren Verhältnisses von Fe:Mn frei variiert werden.

Beispiel 7:

Herstellung von $CuMnO_2$:

Das Herstellungsverfahren wurde grundsätzlich analog zum ersten Ausführungsbeispiel durchgeführt. Als Edukte wurden $Cu(II)SO_4*5\,H_2O$ und $MnSO_4$ in wässriger Lösung verwendet. Der pH-Wert der Lösung wurde auf einen Wert von etwa 11 eingestellt, während die Temperatur der Lösung auf etwa 65 °C eingestellt wurde. Nach dem Abtrennen und einer Alterung der Fällungsprodukte über etwa 8 Stunden wurde $CuMnO_2$ als reine Phase erhalten.

Beispiel 8:

Herstellung von $(CuxPd_{x-1})FeO_2$ mit 0<x<1:

Das Herstellungsverfahren wurde grundsätzlich analog zum ersten Ausführungsbeispiel durchgeführt. Als Edukte wurden $Cu(II)SO_4*5\,H_2O$, $PdSO_4$ und $Fe(II)SO_4*7\,H_2O$ in wässriger Lösung verwendet. Der pH-Wert der Lösung wurde auf einen Wert von etwa 11 eingestellt, während die Temperatur der Lösung auf etwa 60 °C bis 65 °C eingestellt wurde. Nach dem Abtrennen und einer Alterung der Fällungsprodukte über etwa 8 Stunden wurde $(Cu_xPd_{x-1})FeO_2$ als reine Phase erhalten. Der Index x kann durch entsprechende Wahl des eingesetzten molaren Verhältnisses von Cu:Pd frei variiert werden.

Beispiel 9:

Herstellung von $CuFeO_2$ (Delafossit)

Es wurden $FeSO_4*7\,H_2O$ und $CuSO_4*5\,H_2O$ mit einer $Cu^{2+}$-Konzentration von 10 g/L in Wasser gelöst. Das Molverhältnis von Kupfer zu Eisen entsprach etwa 1:1. Eine Erstalkalisierung auf einen pH-Wert von etwa 11 wurde innerhalb von 30 Sekunden durch Zugabe entsprechender Mengen von 32%iger NaOH-Lauge durchgeführt. Die Reaktionstemperatur betrug 70 °C. Der pH-Wert der Reaktionslösung wurde durch wiederholte Zugabe von weiterer NaOH-Lauge für 5 Minuten auf oder über pH 10 gehalten ("pH-Stat-Zeit"). Die Zugabe kann in Abhängigkeit des gemessenen pH-Werts automatisiert durch einen Titrator erfolgen, um den pH-Wert in einem vorbestimmten Fenster bzw. pH-Bereich zu halten. Im Anschluss wurden die Fällungsprodukte in der Reaktionslösung im offenen oder geschlossenen Gefäß, das heißt gegebenenfalls unter Luftabschluss, bei 70 °C gealtert, wobei die Art des Gefäßes keine Auswirkungen auf das Reaktionsprodukt hatte. Die Alterungszeit kann zwischen 1 und 48 Stunden betragen. Das Altern von mindestens 10 Minuten in Schritt d) ist von Vorteil, um eine möglichst hohe Ausbeute an reinphasigem $CuFeO_2$ zu erhalten, obwohl sich $CuFeO_2$ natürlich auch schon zu früheren Zeitpunkten bildet. Ohne an diese Hypothese gebunden werden zu wollen, gehen die Erfinder davon aus, dass generell eine Reaktionsfront vom an den Überstand angrenzenden Bereich des Niederschlags mit einer bestimmten Geschwindigkeit im Wesentlichen diffusionskontrolliert nach unten zum Boden des Reaktionsgefäßes wandert, so dass die Alterungszeit von verschiedenen individuellen Faktoren abhängen und mit Hilfe von fachüblichen Vergleichsversuchen für den Einzelfall optimiert werden kann.

In den frischen (nicht gealterten) Fällungsprodukten bzw. vor und/oder während der "pH-stat Zeit" wurde mindestens eine prozesswirksame Phase, insbesondere Grüner Rost festgestellt, der als Reduktionsmittel wirkte. Der Bildung des Delafossites gingen mehrere Zwischenphasen wie z.B. Cuprit und Ferrihydrite voraus. Die nach dem Erreichen des pH-Wertes gemessene Konzentration von Kupfer bzw. Eisen in der Lösung lag zwischen 0,5 und 2 mg/l. Das bedeutet, dass durch den Prozess mindestens 99,98 % des Kupfers und Eisens aus der verwendeten wässrigen Lösung entfernt wurden.

Der derart hergestellte $CuFeO_2$ besteht aus reinphasigen, plättchenförmigen, hexagonalen Partikeln mit einer relativ homogenen Korngrößenverteilung mit durchschnittlichen Partikeldurchmessern im Bereich von etwa 300 nm Durchmesser und etwa 15-17 nm Dicke. Je nach Reaktionsführung sind auch Durchmesser unter 100 nm und Dicken von 5 nm oder weniger möglich.

Der Phasenanteil von 2H-Phase kann z. B. durch eine erhöhte Zugabe von OH⁻-Ionen während der "pH-Stat-Zeit" erhöht werden. Der pH-Wert sollte in dieser Zeit bzw. Reaktionsphase nicht wesentlich unter 10 sinken, was eine entsprechend erhöhte Zugabemenge bzw. Zugaberate an Lauge voraussetzt, da das Reaktionssystem in diesem Stadium OH⁻-Ionen verbraucht. Die Kristallitgröße sinkt in Abhängigkeit der Phase (2H kleiner als 3R).

Beispiel 10:

Herstellung von $CuMnO_2$:

Das Herstellungsverfahren wurde grundsätzlich analog zum ersten Ausführungsbeispiel durchgeführt. Als Edukte wurden $Cu(II)SO_4*5\ H_2O$ und $MnSO_4$ in wässriger Lösung verwendet. Der pH-Wert der Lösung wurde zunächst durch rasche Zugabe von konzentrierter Lauge auf einen Wert von etwa 11 eingestellt, während die Temperatur der Lösung auf etwa 60 °C eingestellt wurde. Der pH-Wert der Reaktionslösung wurde nach dem ersten Einstellen für 5 Minuten über 10 bzw. zwischen etwa 10 und etwa 12 gehalten. Nach dem Abtrennen der Fällungsprodukte wurde $CuMnO_2$ als reine Phase erhalten. Eine zusätzliche Alterung oder Sinterung war nicht erforderlich.

Beispiel 11:

Herstellung von $AgFeO_2$:

Das Herstellungsverfahren wurde grundsätzlich analog zu den vorherigen Ausführungsbeispielen durchgeführt. Als Edukte wurden Ag(I)-Nitrat und Fe(III)-Nitrat in wässriger Lösung verwendet. Der pH-Wert der Lösung wurde auf einen Wert von etwa 11 eingestellt, während die Temperatur der Lösung auf etwa 65 °C eingestellt wurde. Der pH der Reaktionslösung wurde durch wiederholte Laugenzugabe für 5 Minuten über 10 gehalten. Nach dem Abtrennen der Fällungsprodukte wurde $Ag-FeO_2$ als reine Phase erhalten. Eine Alterung oder Sinterung war nicht erforderlich.

Beispiel 12:

Der Niedrig-Temperatur-Delafossit-Prozess wurde zur Abwasserreinigung von unterschiedlichen Industrieabwässern verwendet:

a.) Cu-haltiges Galvanikabwasser

Als Ausgangsstoff wurde Cu-haltiges Galvanikabwasser verwendet. Eisen(II)sulfat wurde zugegeben und der pH-Wert der Lösung auf einen Wert von etwa 9 bis 11 eingestellt. Die Temperatur der Lösung lag zwischen 50 °C und 90 °C. Der pH-Wert der Reaktionslösung wurde mit Hilfe eines Titrators nach einmaligem Erreichen des Ziel-pH-Werts (z. B. pH 11) für etwa 5 Minuten über 10 gehalten. Nach dem Abtrennen der Fällungsprodukte wurde Delafossit ohne weitere Alterung oder Sinterung als reine Phase erhalten. Cu und das zugegebene Fe wurden praktisch vollständig aus dem Abwasser entfernt. Spuren von weiteren im Abwasser enthaltenen Elementen bzw. Metallionen, beispielsweise von Cr, Ni, Sn etc., wurden ebenfalls quantitativ aus dem Wasser entfernt. Je nach Reaktionsführung können diese weiteren Verunreinigungen mit in die Delafossit-Struktur eingebaut oder per Adsorption bzw. per Copräzipitation mitgefällt werden. Durch Variierung der Temperatur und Zeit können einzelne Elemente während der Alterung des Niederschlags z.B. durch Phasenumwandlungen wieder in die Alterungslösung entlassen werden.

b.) Schadstoffhaltige Abwässer mit As und/oder U kontaminiert

Zu einem Arsen- bzw. Uran-haltigen Minenabwasser wurden Cu-Sulfat und Fe-Sulfat im Molverhältnis 1:1 zugegeben, bis die Cu-Konzentration etwa 8 g/L betrug. Anschließend wurde der pH-Wert der Lösung auf einen Wert von etwa 9 bis 11 eingestellt. Die Temperatur der Lösung lag zwischen 50 °C und 90 °C. Zu diesem Zeitpunkt konnte in einem grundsätzlich optionalen Schritt bereits gereinigtes Abwasser zumindest teilweise vom bereits gebildeten Niederschlag abgezogen werden. Anschließend wurde der pH-Wert der Reaktionslösung mit Hilfe eines Titrators nach erstmaligem Erreichen des Ziel-pH-Werts (z. B. 11) für etwa 5 Minuten über 10 gehalten. As und U wurden dabei quantitativ aus der Lösung entfernt und über die metastabilen Zwischenphasen (Hydroxide, Hydroxisalze etc.) des beschriebenen Delafossitprozesses in das Reaktionsprodukt eingebaut bzw. an dieses angelagert. Durch Alterung konnte in Abhängigkeit der Temperatur und Dauer wahlweise eine gezielte Anreicherung der Alterungslösung an As/U oder ein Einbau von As/U in den Delafossit erzielt werden, so dass Delafossit als Fang- und Speichermineral für diese toxischen bzw. radiaktiven Verunreinigungen verwendet werden kann.

Beispiel 13:

Herstellung von $CuMnO_2$:

Das Herstellungsverfahren wurde grundsätzlich analog zum ersten Ausführungsbeispiel durchgeführt. Als Edukte wurden $Cu(II)SO_4*5\,H_2O$ und $MnSO_4$ in wässriger Lösung verwendet. Der pH-Wert der Lösung wurde initial auf einen Wert von etwa 11 eingestellt, während die Temperatur der Lösung auf etwa 65 °C eingestellt wurde. Der pH wurde anschließend 7 Minuten über 10 gehalten. Nach dem Abtrennen und einer Alterung der Fällungsprodukte über etwa 10 Minuten wurde $CuMnO_2$ als reine Phase erhalten.
Die grundsätzlichen Vorteile des erfindungsgemäßen Verfahrens sind:

- Synthese bei niedrigen Temperaturen $\leq 95$ °C und Atmosphärendruck möglich, dadurch Verzicht auf Autoklaven und dergleichen möglich
- Umgehung der bislang aufwändigen und teuren Syntheseverfahren wie z.B. Sol-Gel-Synthese, Festkörpersyntheseverfahren oder Hydrothermalsynthese
- Geringerer Energieverbrauch
- Geringerer technischer Aufwand und hohes Maß an Automatisierbarkeit
- Kontinuierliche oder chargenweise Durchführung möglich

Versuchsergebnisse des erfindungsgemäß hergestellten Produkts $AXO_2$ zeigen, dass das Material spezielle magnetische, optische, elektrische und antimikrobielle Eigenschaften aufweist. Dies eröffnet verschiedene neue An-wendungsmöglichkeiten von $AXO_2$-Verbindungen:

- $AXO_2$-Verbindungen als Katalysatoren in "p-type conducting" Oxiden und Batterien
- $AXO_2$-Verbindungen als photochemische, elektrochemische und/oder antibakterielle Wirkstoffe, beispielsweise für Verbundmaterialien oder in der Photovoltaik
- $AXO_2$-Phasen als Speichermineral für verschiedene toxische und/oder radiaktive Elemente
- Verwendung der $AXO_2$ Fällungsreaktion für die Wasserreinigung, beispielsweise für die Reinigung von Industrieabwässern (insbesondere von Abwässern, die durch die Behandlung von Metalloberflächen entstehen)

Die in den Unterlagen angegebenen Parameterwerte zur Definition von Prozess- und Messbedingungen für die Charakterisierung von spezifischen Eigenschaften des Erfindungsgegenstands sind auch im Rahmen von Abweichungen - beispielsweise aufgrund von Messfehlern, Systemfehlern, Einwaagefehlern, DIN-Toleranzen und dergleichen - als vom Rahmen der Erfindung mitumfasst anzusehen.

**Patentansprüche**

1. Verfahren zum Herstellen einer anorganischen Verbindung der allgemeinen Formel $AXO_2$, in welcher A wenigstens ein Element aus der Gruppe Cu, Ag, Pd, Pt, Au, Na und Li und X wenigstens ein von A verschiedenes metallisches Element aus der Gruppe der Übergangsmetalle, der Leichtmetalle, der Seltenerdmetalle und/oder des p-Blocks sind, umfassend die Schritte:

   a) Bereitstellen einer wässrigen Lösung, die gelöste Kationen von A und X enthält;
   b) Einstellen einer Temperatur der wässrigen Lösung auf einen Wert von höchstens 95 °C;
   c) Einstellen eines pH-Werts der wässrigen Lösung auf einen Wert zwischen 0 und 14 unter Ausbildung von Fällungsprodukten; und
   d) Alterung der Fällungsprodukte bei mindestens 35 °C für mindestens 10 Minuten unter Ausbildung von $AXO_2$.

2. Verfahren nach Anspruch 1,
   **dadurch gekennzeichnet, dass**
   X ausgewählt wird aus der Gruppe Mg, Y, Fe, Mn, Cr, Co, Ni, Zn, Al, Ga, Sn, Au, Rh, In und Sc.

3. Verfahren nach Anspruch 1 oder 2,
   **dadurch gekennzeichnet, dass**
   in Schritt a) ein Molverhältnis von A:X auf einen Wert zwischen 0,9 und 1,1 eingestellt wird und/oder dass eine Konzentration der Kationen von A und/oder X in Schritt a) auf mindestens 1 g/l eingestellt wird.

4. Verfahren nach einem der Ansprüche 1 bis 3,
**dadurch gekennzeichnet, dass**
zumindest einer der Schritte a), b) c) und d) unter einem Druck von höchstens 1,4 bar, insbesondere unter Atmosphärendruck durchgeführt wird.

5. Verfahren nach einem der Ansprüche 1 bis 4,
**dadurch gekennzeichnet, dass**
der pH-Wert in Schritt c) durch vorzugsweise mehrfache Zugabe von Hydroxid-Ionen, insbesondere durch Alkalihydroxid und/oder Alkalilauge und/oder durch vorzugsweise mehrfache Zugabe einer Säure, insbesondere einer Mineralsäure aus der Gruppe HCl, $HNO_3$ und $H_2SO_4$ eingestellt wird.

6. Verfahren nach einem der Ansprüche 1 bis 5,
**dadurch gekennzeichnet, dass**
die Fällungsprodukte in Schritt d) in wässriger Umgebung altern, wobei ein pH-Wert der wässrigen Umgebung vorzugsweise wenigstens einmal auf einen vorbestimmten Mindestwert eingestellt und/oder für eine vorbestimmte Zeitdauer auf einem vorbestimmten Mindestwert gehalten wird und/oder dass die Fällungsprodukte in Schritt d) bei einer Temperatur von höchstens 100 °C altern.

7. Verfahren nach einem der Ansprüche 1 bis 6,
**dadurch gekennzeichnet, dass**
Schritt d) abgebrochen wird, sobald ein mittlerer Partikeldurchmesser der anorganischen Verbindung der Formel $AXO_2$ 1000 nm beträgt oder übersteigt und/oder sobald eine mittlere Partikeldicke der anorganischen Verbindung der Formel $AXO_2$ 50 nm beträgt oder übersteigt.

8. Verfahren nach einem der Ansprüche 1 bis 7,
**dadurch gekennzeichnet, dass**
in Schritt a) als wässrige Lösung ein Abwasser, insbesondere ein Industrieabwasser verwendet wird.

9. Anorganischen Verbindung der allgemeinen Formel $AXO_2$, in welcher A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind, erhältlich und/oder erhalten durch ein Verfahren gemäß einem der Ansprüche 1 bis 8.

10. Anorganische Verbindung nach Anspruch 9,
**dadurch gekennzeichnet, dass**
$AXO_2$ eine Delafossit-Struktur besitzt und/oder als Partikel mit einem mittleren Partikeldurchmesser von höchstens 1000 nm und/oder mit einer mittleren Partikeldicke von höchstens 50 nm vorliegt.

11. Anorganische Verbindung nach Anspruch 9 oder 10,
**dadurch gekennzeichnet, dass**
$AXO_2$ die Formel $AgFeO_2$, $CdFeO_2$, $PdFeO_2$, $PtFeO_2$, $AuFeO_2$, $LiFeO_2$, $CuFeO_2$, $CuCrO_2$, $AgCrO_2$, $CuMnO_2$, $CuNiO_2$, $PdFeO_2$, $PdCrO_2$, $PdMnO_2$, $PdCoO_2$, $PtCoO_2$, $CuInO_2$, $CuYO_2$, $CuAlO_2$, $CuGaO_2$, $AgNiO_2$, $AgInO_2$, $PdCoO_2$, $CuCoO_2$, $AgFeO_2$, $PtCoO_2$, $LiCoO_2$, $AgCoO_2$, $CuLaO_2$, $LiNiO_2$, $AgA\text{-}IO_2$, $LiMnO_2$ oder $CuSnO_2$ besitzt.

12. Anorganische Verbindung nach Anspruch 9 oder 10,
**dadurch gekennzeichnet, dass**
A mehrere Elemente $A^n$ mit $2 \leq n \leq 6$ aus der Gruppe Cu, Ag, Pd, Pt, Au, Na und Li umfasst und/oder dass X mehrere metallische Elemente $X^m$ mit $m \geq 2$ aus der Gruppe der Übergangsmetalle, der Leichtmetalle, der Seltenerdmetalle und/oder des p-Blocks umfasst.

13. Anorganische Verbindung nach Anspruch 12,
**dadurch gekennzeichnet, dass**
diese die Formel $Li(Mn, Ni, Co)O_2$, $Cu(Fe_{1-x}Cr_x)O_2$, $Cu(Fe_{1-x}Mn_x)O_2$, $(Cu_xPd_{x-1})FeO_2$, $CuFe_{1-x}Sn_xO_2$, $CuCr_{1-x}Mg_xO_2$, $CuFe_{1-x}Al_xO2$, $CuCr_{1-x}Mg_xO_2$ oder $CuCr_{1-x}Ni_xO_2$ mit $0<x<1$ besitzt.

14. Anorganische Verbindung nach einem der Ansprüche 9 bis 13,

**dadurch gekennzeichnet, dass**

diese mit wenigstens einem Element, das aus der Gruppe As und Li ausgewählt ist, und/oder mit wenigstens einem radiaktiven Element mit einer Ordnungszahl $\geq 55$ dotiert ist.

15. Verwendung einer anorganischen Verbindung der allgemeinen Formel $AXO_2$, in welcher A wenigstens ein Element aus der Gruppe Cu, Ag, Pd, Pt, Au, Na und Li und X wenigstens ein metallisches und von A verschiedenes Element aus der Gruppe der Übergangsmetalle, der Leichtmetalle, der Seltenerdmetalle und/oder des p-Blocks sind, wobei die anorganische Verbindung erhältlich und/oder erhalten durch ein Verfahren gemäß einem der Ansprüche 1 bis 8 und/oder gemäß einem der Ansprüche 9 bis 14 ausgebildet ist, als Katalysator und/oder als photochemisches und/oder elektrochemisches und/oder antimikrobiell wirksames Material und/oder als Speichermaterial für toxische und/oder radioaktive Elemente und/oder zur Reinigung von Abwässern und/oder zur Herstellung von Solarzellen und/oder als Spintronik-Werkstoff, insbesondere als spintronischer Speicher.

Europäisches Patentamt

European Patent Office

Office européen des brevets

# EUROPÄISCHER RECHERCHENBERICHT

**Nummer der Anmeldung**

EP 16 19 2872

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | KREHULA STJEPKO ET AL: "Formation of AgFeO2, [alpha]-FeOOH, and Ag2O from mixed Fe(NO3)3-AgNO3solutions at high pH", JOURNAL OF MOLECULAR STRUCTURE, ELSEVIER, AMSTERDAM, NL, Bd. 1044, 15. November 2012 (2012-11-15), Seiten 221-230, XP028555993, ISSN: 0022-2860, DOI: 10.1016/J.MOLSTRUC.2012.11.012 * Seiten 221,222; Abbildungen 2,10b * * Seite 229 * ----- | 1-11,15 | INV. C01G19/00 B01J23/00 C01G37/00 C01G45/12 C01G49/00 C01G51/00 C01G53/00 C01G55/00 C01G3/00 C01G5/00 C01G15/00 C02F9/00 C11D3/00 G21F9/00 H01L43/08 H01L31/00 H01M4/00 |
| X | CN 104 058 461 A (UNIV WUHAN TECH) 24. September 2014 (2014-09-24) | 1-11,15 | |
| A | * das ganze Dokument * ----- | 12-14 | |
| X | SEKI S ET AL: "Impurity-doping induced ferroelectricity in frustrated antiferromagnet CuFeO2", ARXIV.ORG, CORNELL UNIVERSITY LIBRARY, 201 OLIN LIBRARY CORNELL UNIVERSITY ITHACA, NY 14853, 9. November 2006 (2006-11-09), XP080260529, | 9-13 | |
| A | * Seite 1 * | 1-8,14, 15 | |
| X | DE 10 2012 214021 A1 (OSRAM OPTO SEMICONDUCTORS GMBH [DE]) 13. Februar 2014 (2014-02-13) | 9-15 | |
| A | * Absätze [0037], [0038], [0057], [0085], [0162] * ----- | 1-8 | |

**RECHERCHIERTE SACHGEBIETE (IPC)**

C01G
B01J
C02F
C11D
G21F
H01L
H01M

Der vorliegende Recherchenbericht wurde für alle Patentansprüche erstellt

| Recherchenort | Abschlußdatum der Recherche | Prüfer |
|---|---|---|
| München | 9. Dezember 2016 | Nobis, Barbara |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 16 19 2872

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-12-2016

| Im Recherchenbericht angeführtes Patentdokument | Datum der Veröffentlichung | Mitglied(er) der Patentfamilie | Datum der Veröffentlichung |
|---|---|---|---|
| CN 104058461 A | 24-09-2014 | KEINE | |
| DE 102012214021 A1 | 13-02-2014 | CN 104521022 A | 15-04-2015 |
| | | DE 102012214021 A1 | 13-02-2014 |
| | | KR 20150041097 A | 15-04-2015 |
| | | US 2015200378 A1 | 16-07-2015 |
| | | WO 2014023478 A1 | 13-02-2014 |

EPO FORM P0461

Für nähere Einzelheiten zu diesem Anhang : siehe Amtsblatt des Europäischen Patentamts, Nr.12/82